(19) Europäisches Patentamt
European Patent Office
Office européen des brevets

(11) EP 3 206 465 A1

(12) EUROPEAN PATENT APPLICATION

(43) Date of publication:
16.08.2017 Bulletin 2017/33

(51) Int Cl.:
H05K 1/02 (2006.01)    H05K 1/14 (2006.01)

(21) Application number: 17156061.8

(22) Date of filing: 14.02.2017

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 15.02.2016 JP 2016025932

(71) Applicant: Funai Electric Co., Ltd.
Daito,
Osaka, 574-0013 (JP)

(72) Inventor: ISHIDA, Toshiyuki
Daito, Osaka 574-0013 (JP)

(74) Representative: Global IP Europe
Patentanwaltskanzlei
Pfarrstraße 14
80538 München (DE)

(54) DISPLAY DEVICE

(57)    A display device is basically provided that comprises a display, two circuit boards, and a cable. The cable connects the circuit boards together and includes a sheet-form wiring component having a first face and a second face on the opposite side from the first face, a first insulating part that is disposed on the first face, and a shield component that is disposed on the first insulating part and shields electromagnetic waves. The cable has a bent part that is bent to a second face side. The angle $\alpha$ formed by a direction towards one end of the wiring component from the bent part and a direction towards the other end of the wiring component from the bent part is $0° < \alpha < 180°$.

FIG. 2A

EP 3 206 465 A1

*FIG. 2B*

## Description

BACKGROUND

Field of the Invention

The present invention relates to a display device.

Background Information

In electronic devices, a flat cable referred to as an FFC (flexible flat cable) is sometimes used to transmit signals. Both sides of this FFC are covered by a shield component made of metal, and the conductor (that is, the signal wire) is electrically isolated from the external environment.

There is a known transmission line that includes a flat cable formed in a strip by bundling a plurality of signal lines in a planar shape, and a shield member that covers the flat cable. The flat cable is bent at a right angle at a location that is one-half the wavelength of the noise to be reduced from the end (see JP 2013-191971 A).

SUMMARY

The above-mentioned shield members that are on both sides of an FFC can be considered to be effective at shielding interference from the outside and preventing distortion of signals. Also, these shield members on both sides are good at preventing changes in the characteristic impedance of the FFC caused by contact between the FFC and the metal present in an electronic device. However, shielding both sides of an FFC can drive up the cost of the finished product. Also, an FFC is sometimes bent midway along its wiring, and depending on how it is bent, this can bring about deterioration in the signals being transmitted.

One object is to provide a display device with which good quality of transmitted signals can be maintained, while avoiding a cost increase.

[1] In view of the state of the known technology and in accordance with a first aspect of the present invention, a display device is provided that comprises a display, two circuit boards, and a cable. The two circuit boards are configured to be electrically connected to the display. The cable electrically connects the circuit boards and includes a sheet-form wiring component having a first face and a second face on the opposite side from the first face, a first insulating part that is disposed on the first face, and a shield component that is disposed on the first insulating part and shields electromagnetic waves. The cable has a bent part that is bent to a second face side. The angle $\alpha$ formed by a direction towards one end of the wiring component from the bent part and a direction towards the other end of the wiring component from the bent part is $0° < \alpha < 180°$.

With this mode, fluctuation in the characteristic impedance of the cable that is shielded on one side is minimized, and the quality of the signal can be maintained. The two circuit boards may be directly or indirectly connected to the display such that electric signal is transmitted from each circuit board to the display and/or vice versa. The signal may be transmitted directly between each circuit board and the display. The signal may be transmitted indirectly via any unit or any other circuit board which is electrically located between each circuit board and the display. Each circuit board constituting the two circuit boards may be any circuit board. Examples of the circuit board are a power supply board on which a power supply circuit is installed, a digital board configured to control the entire display device, a panel drive board on which a drive circuit for a liquid crystal panel of the display is installed, and a display drive board configured to drive the display under the control of the digital board. The electric signal transmitted to/from a circuit board may be any kind of electric signal. An example of the electric signal is voltage or current provided by the power supply circuit board. Other examples of the electric signal are digital signal for controlling the display device, signal for driving the liquid crystal panel of the display, and signal for driving the display.

[2] In accordance with a preferred embodiment according to the display device mentioned above, the angle $\alpha$ is $27° \le \alpha < 180°$.

[3] In accordance with a preferred embodiment according to any one of the display devices mentioned above, the angle $\alpha$ is $60° \le \alpha < 180°$.

[4] In accordance with a preferred embodiment according to any one of the display devices mentioned above, the number of bends of the cable is an even number.

[5] In accordance with a preferred embodiment according to any one of the display devices mentioned above, the shield component is disposed over an entire surface of the first face.

[6] In accordance with a preferred embodiment according to any one of the display devices mentioned above, the shield component is disposed only on the first face out of the first and second faces.

[7] In accordance with a preferred embodiment according to any one of the display devices mentioned above, the circuit boards include a drive board that is configured to transmit drive signal to the display, and a control board that is configured to control the drive board.

[8] In accordance with a preferred embodiment according to any one of the display devices mentioned above, the cable includes a second insulating part that covers at least a part of the second face.

[9] In accordance with a preferred embodiment according to any one of the display devices mentioned above, the display device further comprises a metallic component that forms a component of the display device. A part of the second insulating part of the cable is located closer to the metallic component relative to the wiring component.

[10] In accordance with a preferred embodiment according to any one of the display devices mentioned above, the cable includes a third insulating part that covers at least a part of the shield component.

[11] In accordance with a preferred embodiment according to any one of the display devices mentioned above, the display device further comprises a metallic component that forms a component of the display device. A part of the third insulating part of the cable is located closer to the metallic component relative to the wiring component.

[12] In accordance with a preferred embodiment according to any one of the display devices mentioned above, the area of the third insulating part facing with the metallic component is larger than the area of the second insulating part facing with the metallic component.

[13] In accordance with a preferred embodiment according to any one of the display devices mentioned above, the display device further comprises a metallic component that forms a component of the display device. The shield component is located closer to the metallic component relative to the wiring component.

[14] In accordance with a preferred embodiment according to any one of the display devices mentioned above, the angle $\alpha$ is $0° < \alpha < 180°$ as viewed in a direction perpendicular to a main surface of the cable.

[15] In accordance with a preferred embodiment according to any one of the display devices mentioned above, the angle $\alpha$ is $0° < \alpha < 180°$ as viewed in a direction parallel to a main surface of the cable.

[16] In accordance with a preferred embodiment according to any one of the display devices mentioned above, the display device further comprises a metallic component that forms a component of the display device. The area of the shield component facing with the metallic component being larger than the area of the second face facing with the metallic component.

[17] In accordance with a preferred embodiment according to any one of the display devices mentioned above, the display device further comprises a metallic component that forms a component of the display device. The distance between the cable and the metallic component over a range where the second face of the cable faces with the metallic component is more than or equal to a predetermined distance.

[18] In accordance with a preferred embodiment according to any one of the display devices mentioned above, the predetermined distance is a distance at which the fluctuation in the characteristic impedance of the cable is less than or equal to 10%.

For example, the display device comprises a metal support on which the circuit boards are disposed. A distance between the support and the cable over the range in which a face of the cable on the side where the shield component is not disposed is opposite the support is a distance at which the fluctuation in the characteristic impedance of the cable is less than or equal to 10%.

[19] In accordance with a preferred embodiment according to any one of the display devices mentioned above, the circuit boards are disposed on the metallic component.

[20] In accordance with a preferred embodiment according to any one of the display devices mentioned above, the predetermined distance is a distance at which the fluctuation in the characteristic impedance of the cable is less than or equal to 10%.

The technological concept of the present invention can be realized by other modes besides a display device. For example, a connection structure having boards included in a device and a cable that connects to these boards can itself constitute an invention. Also, a method for realizing a cable connection structure can constitute an invention.

BRIEF DESCRIPTION OF THE DRAWINGS

Referring now to the attached drawings which form a part of this original disclosure:

FIGS. 1A, 1B, 1C, and 1D illustrate the configuration of an FFC in accordance with a first embodiment;

FIGS. 2A and 2B are schematic diagrams of internal configurations of a display device, as an example of an electronic device, in accordance with a first embodiment;

FIG. 3 illustrates an example of a routing of the FFC shown in FIG. 1, illustrating an unshielded side of the FFC is bent inward;

FIGS. 4A and 4B illustrate examples of the routing of the FFC shown in FIG. 1, illustrating the unshielded side is bent inward;

FIG. 5 illustrates an example of a routing of an FFC in accordance with a second embodiment, illustrating the FCC having a bent part that includes a plurality of bends (three times);

FIGS. 6A and 6B illustrate examples of a routing of an FFC in accordance with a third embodiment, illustrating the FFC having a bent part that includes a plurality of bends (two times);

FIGS. 7A and 7B illustrate examples of the routing of the FFC in accordance with the third embodiment, illustrating the FFC having a bent part that includes a plurality of bends (two times);

FIGS. 8A and 8B illustrate examples of routings of the FFCs shown in FIGS. 3 and 5, in accordance with a fourth embodiment, illustrating the bent parts of the FFCs are fixed with tape;

FIGS. 9A and 9B illustrate examples of routings of the FFC shown in FIG. 5, in accordance with the fourth embodiment, illustrating the FFC is fixed to a sheet metal with tape;

FIGS. 10A and 10B illustrate an example of a routing of an FFC in accordance with a fifth embodiment, illustrating the FFC being disposed to avoid an obstacle; and

FIG. 11 illustrates a table of the relation between the angle $\alpha$ and the coefficient of variation in the characteristic impedance in accordance with the first embodiment; and

FIG. 12 illustrates a side view of the FFC shown in FIG. 4B as viewed in a parallel direction parallel to a main surface of the FFC.

## DETAILED DESCRIPTION OF PREFERRED EMBODIMENTS

Selected embodiments will now be explained with reference to the drawings. It will be apparent to those skilled in the art from this disclosure that the following descriptions of the embodiments are provided for illustration only and not for the purpose of limiting the invention as defined by the appended claims. Configurations in which two or more embodiments are suitably combined are also within the scope disclosed by the present invention. The drawings are nothing more than examples given to describe the embodiments, and the shapes, dimensions, proportions, and so forth can vary from one drawing to the next.

## FIRST EMBODIMENT

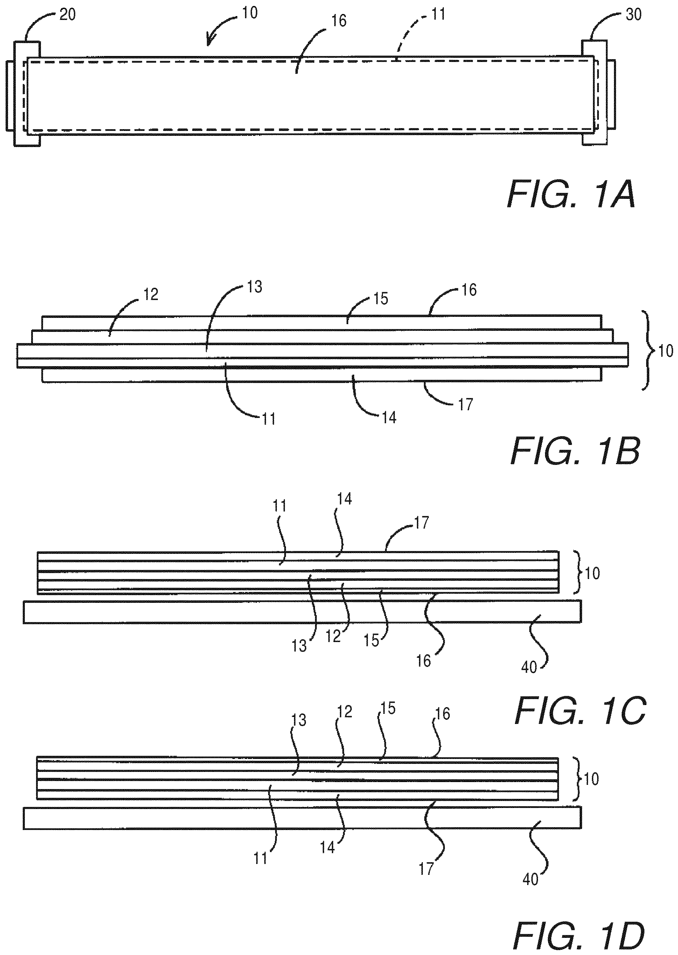

FIG. 1 A is an example of a top view of an FFC 10 pertaining to this embodiment. FIG. 1B is an example of a cross section of the FFC 10. However, the cross section in FIG. 1B (and FIGS. 1C and 1D) does not include hatching over the cut sections, in order to make the drawing easier to see.

The FFC 10 is an example of a cable that is connected at one end to a connector 20 (a first connector) and connected at the other end to a connector 30 (second connector). The connectors 20 and 30 are electrically connected to circuit boards installed inside an electronic device. Consequently, the FFC 10 (e.g., cable) connects the circuit boards together, and is used for signal transmission between the circuit boards. A connection using the FFC 10 is called a cable connection structure. The FFC 10 has a sheet-form wiring component (a conductor component 11) having a first face and a second face on the opposite side from the first face, and a shield component (a shield member 12) that is disposed on the first face (the first face side). As an example, the FFC 10 has a flat (sheet-form) conductor component 11, a shield member 12 (e.g., a shield component), and an insulating film 13 (e.g., a first insulating part). The conductor component 11 includes a plurality of conductors (signal wires) arranged in a direction (width direction) that intersects the extension direction (lengthwise direction) of the conductors. The conductors or the conductor component 11 are example of a wiring component that transmits signals. The conductor component 11 has a first face (an upper surface of the conductor component 11 in FIG. 1B, and a lower surface of the conductor component 11 in FIG. 1 C), and a second face (a lower surface of the conductor component 11 in FIG. 1B, and an upper surface of the conductor component 11 in FIG. 1 C) that is on the opposite side from the first face. The insulating film 13 is disposed on the first face of the conductor component 11. The shield component is disposed on the insulating film 13 and shields electromagnetic waves. Also, of the two sides or faces of the conductor component 11, the entire surface of the first face is covered by the shield member 12 (e.g., shield component), which is a member that shields electromagnetic waves, while the second face (of the two sides) is not covered by the shield member 12. That is, the FFC 10 is shielded on just one side. Thus, in the illustrated embodiment, the shield member 12 (e.g., the shield component) is made of a member or material that shields electromagnetic waves. Also, in the illustrated embodiment, the shield member 12 (e.g., the shield component) is disposed over the entire surface of the first face. Also, in the illustrated embodiment, the shield member 12 (e.g., the shield component) is disposed only on the first face out of the first and second faces.

More precisely, as shown in FIG. 1B, the two sides of the conductor component 11 are covered by the insulating film 13 (e.g., the first insulating part) and an insulating film 14 (e.g., a second insulating part). The face on the side covered by the insulating film 13 (of the insulating films 13 and 14) is further covered by the shield member 12. The shield member 12 is covered by an insulating film 15 (e.g., a third insulating part). Therefore, what is seen on the outside of the FFC 10 is the insulating film 15 on one side, and the insulating film 14 on the other side. Hereinafter, when referring to the outside view of the FFC 10, the face on the insulating film 15 side, that is, the face on the side where the conductor component 11 is covered by the shield member 12, will also be called the shielded face 16, and the face on the insulating film 14 side, that is, the face on the side where the conductor component 11 is not covered by the shield member 12, will also be called the unshielded face 17. FIG. 1 A mainly shows the shielded face 16. The shielded face 16 also corresponds to the face on the side where a conductive member is disposed, while the unshielded face 17 also corresponds to the face on the side where the conductor component 11 (e.g., the wiring component) is disposed. Thus, in the illustrated embodiment, the FFC 10 (e.g., the cable) includes the insulating film 13 (e.g., the first insulating part) that is disposed between the conductor component 11 (e.g., the wiring component) and the shield member 12 (e.g., the shield component), as shown in FIG. 1B. Also, in the illustrated embodiment, the FFC 10 (e.g., the cable) includes the insulating film 14 (e.g., the second insulating part) that covers at least a part of the second face of the conductor component 11, as shown in FIG. 1B. Also, in the illustrated embodiment, the FFC 10 (e.g., the cable) includes the insulating film 15 (e.g., the third insulating part) that covers at least a part of the shield member 12 (e.g., the shield component), as shown in FIG. 1B.

In a state in which the FFC 10 is connected to the connectors 20 and 30, the shield member 12 is connected to the ground terminals of the connectors 20 and 30. Therefore, the shield member 12 is usually grounded via these ground terminals. The connectors 20 and 30 are not shown in FIG. 1B.

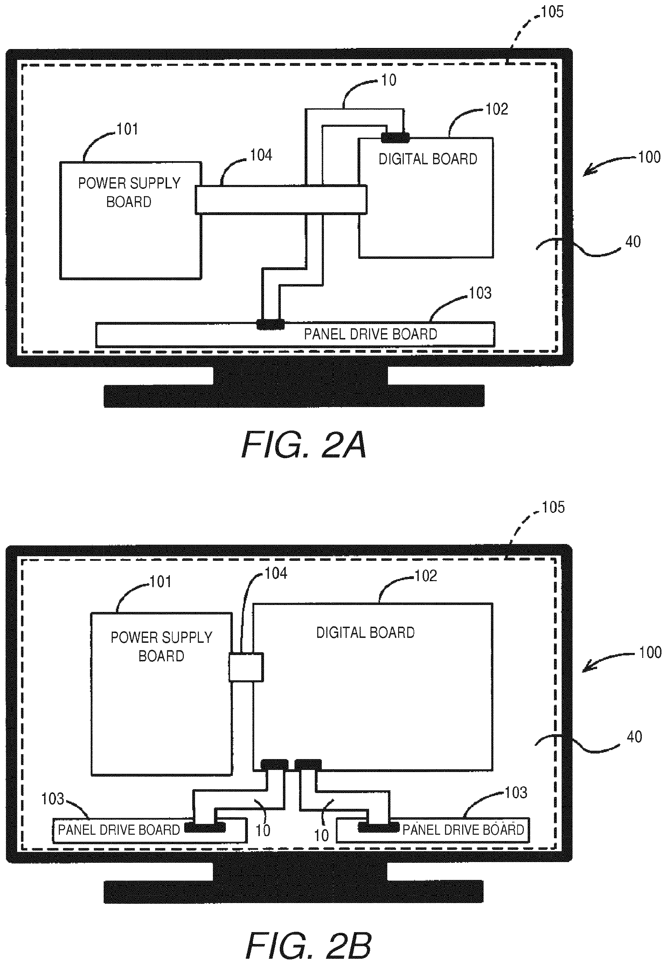

FIGS. 1C and 1 D are cross sections that show an example of the positional relation between part of a metal sheet 40 and part of the FFC 10. The metal sheet 40 is a member included in an electronic device having a connection structure that makes use of the FFC 10. The electronic device is, for example, the display device 100 shown in FIGS. 2A and 2B.

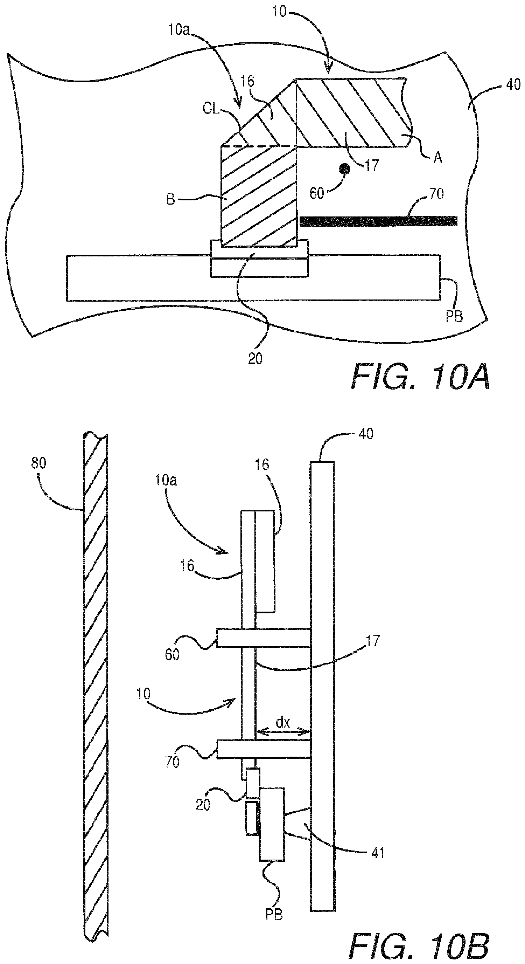

FIGS. 2A and 2B each show a simplified example of the internal structure of the display device 100 as seen from the back side of the display device 100. The display device 100 has the substantially rectangular metal sheet 40 that covers one side (the rear side) of a liquid crystal panel 105 (indicated by a broken line), and various circuit boards (a power supply board 101 on which a power supply circuit is installed, a digital board 102 that controls the entire device, a panel drive board 103 on which the drive circuit for the liquid crystal panel is installed (a display drive board for driving a display panel (display) under the control of the digital board 102), and so forth) are installed on the rear face of the metal sheet 40. Thus, in the illustrated embodiment, the power supply board 101, the digital board 102, and the panel drive board 103 (e.g., the circuit boards) are disposed on the metal sheet 40 (e.g., the metallic component). The FFC 10 is used to connect at least one pair of these boards. In the examples in FIGS. 2A and 2B, the FFC 10 connects the digital board 102 and the panel drive board 103, which allows for the transmission of signals between these boards 102 and 103. The signals transmitted by the FFC 10 between the boards 102 and 103 are high-frequency waves. 104 is a cable that connects the power supply board 101 to the digital board 102. With this mode, at least part of the range of the FFC 10 can be said to be disposed along the metal sheet 40. The display device 100 can be called a liquid crystal display device in that it has the liquid crystal panel 105 as its display panel. However, the display device 100 can instead have a plasma display, an organic EL display, or the like as its display panel. Although not depicted in FIGS. 2A and 2B, the display device 100 has a rear cabinet that covers the rear side of the liquid crystal panel 105 (see 80 in FIG. 10B). The rear cabinet 80 corresponds to a housing disposed on one side of the display panel. The various above-mentioned circuit boards, the FFC 10, the metal sheet 40, and so forth can also be said to be housed within the rear cabinet 80. The panel drive board 103 can also be expressed as a drive board that transmits drive signals to a display panel, and the digital board 102 can also be expressed as a control board that controls the drive board.

As shown in FIG. 1C, the FFC 10 is disposed in an orientation in which the shielded face 16 faces the metal sheet 40 side. The shielded face 16 here may or may not be in contact with the metal sheet 40. Thus disposing the shielded face 16 facing the metal sheet 40 side of the FFC 10 that is shielded on just one side helps avoid such problems as fluctuation in the characteristic impedance or the distortion or waveform blunting of signals when the unshielded face 17 comes into contact with or comes close to the metal sheet 40. Also, this effect can be attained less expensively than when using an FFC that is shielded on both side. Thus, in the illustrated embodiment, the circuit boards include the panel drive board 103 (e.g., the drive board) that is configured to transmit the drive signal to the liquid crystal panel 105 (e.g., the display), and the digital board 102 (e.g., the control board) that is configured to control the panel drive board 103. Also, in the illustrated embodiment, the display device 100 includes the metal sheet 40 (e.g., the metallic component) that forms a component of the display device 100.

Depending on their structure, the connectors 20 and 30 can have the above-mentioned ground terminals on the upper side. The upper side referred to here is the upper side when we call the side on which the boards are located the lower side, in a state in which the connectors 20 and 30 have been connected on the boards. When these connectors 20 and 30 are employed, in order for the shield member 12 to be connected to the above-mentioned ground terminals of the connectors 20 and 30, the shielded face 16 of the FFC 10 will by necessity be facing up, and the unshielded face 17 will be facing down. However, in this state, the FFC 10 installed along the metal sheet 40 will end up being in an orientation in which the unshielded face 17 is facing the metal sheet 40 side. In view of this, in this embodiment the FFC 10 is bent to avoid as much as possible a situation in which the unshielded face 17 faces the metal sheet 40 side. The FFC 10 can be bent because it is flexible. The concept of bending the FFC 10 encompasses both folding the FFC 10 and curving it without folding.

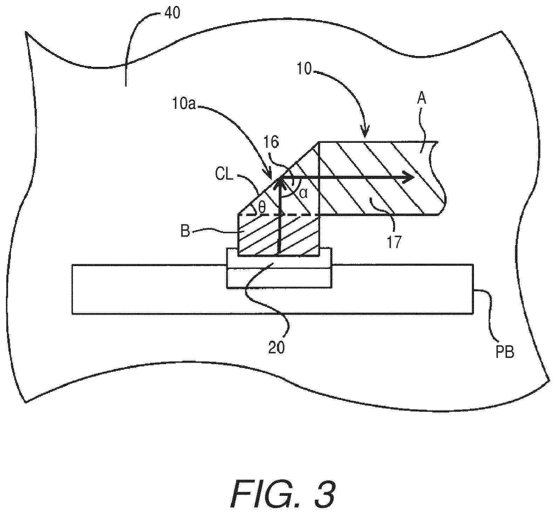

FIG. 3 shows an example of part of the FFC 10 disposed on the metal sheet 40 and extending from the connector 20 connected to a circuit board PB, as well as the area around this part. This part includes the portion where the FFC 10 is bent (the bent part 10a). The circuit board PB corresponds to any of the boards shown in FIGS. 2A and 2B, for example. As shown in FIG. 3, the FFC 10 extends from the connector 20 in a state in which the shielded face 16 is facing up (the opposite side from the side where the metal sheet 40 is located). In this state, the FFC 10 has the bent part 10a that is bent to the second face side, that is, the bent part 10a that is bent so that the unshielded face 17 is on the inside. In the example in FIG. 3, the bent part 10a is bent at an angle of 90°.

The "bending angle" is the angle formed by the direction in which the FFC 10 faces after bending, with respect to the direction in which the FFC 10 is facing before bending. In this embodiment, the term "angle of crease" or "angle of folding line" will also be used in addition to bending angle. The angle of crease or the angle of folding line refers to the angle formed by the straight line (crease or folding line CL) produced in the width of the FFC 10 by the bending of the FFC 10, and the direction in which the FFC 10 faces (a line to the side of the FFC). The bending angle is twice the angle of crease. In the example in FIG. 3, the angle of crease θ = 45°, and as a result the bending angle is 2θ, or 90°.

When the bent part 10a in the mode shown in FIG. 3 is employed, the FFC 10 is in an orientation such that although the unshielded face 17 is facing the metal sheet 40 side over an extremely small range near the connector 20, outside this range the shielded face 16 is facing the metal sheet 40 side. This minimizes such problems as fluctuation in the characteristic impedance or the distortion or waveform blunting of signals transmitted by the FFC 10, and allows the quality of the signals to be maintained. Naturally, the FFC 10 can also employ the same bending method as that of the FFC 10 shown in FIG. 3 and elsewhere for the area near the connector 30 at the other end. FIG. 3 can be said to show an example in which the surface area A in the range over which the shielded face 16 of the FFC 10 is opposite the metal sheet 40 (the surface area opposite the shielded face) is larger than the surface area B in the range over which the unshielded face 17 is opposite the metal sheet 40 (the surface area opposite the unshielded face). In other words, the FFC 10 has a bent part 10a that is bent such that the surface area A in the range over which the shielded face 16 (first face) is opposite the metal sheet 40 is larger than the surface area B in the range over which the unshielded face 17 (second face) is opposite the metal sheet 40, as shown in FIG. 3. More specifically, the FFC 10 is arranged relative to the metal sheet 40 as shown in FIG. 1C in the surface area A, while the FFC 10 is arranged relative to the metal sheet 40 as shown in FIG. 1 D in the surface area B. In particular, the shielded face 16 directly faces with the metal sheet 40 in the surface area A, while the unshielded face 17 directly faces with the metal sheet 40 in the surface area B. Thus, in the illustrated embodiment, a part of the insulating film 14 (e.g., the second insulating part) of the FFC 10 (e.g., the cable) is located closer to the metal sheet 40 (e.g., the metallic component) relative to the conductor component 11 (e.g., the wiring component), as shown in FIG. 1 D, in the surface area B shown in FIG. 3. Also, in the illustrated embodiment, a part of the insulating film 15 (e.g., the third insulating part) of the FFC 10 (e.g., the cable) is located closer to the metal sheet 40 (e.g., the metallic component) relative to the conductor component 11 (e.g., the wiring component), as shown in FIG. 1C, in the surface area A shown in FIG. 3. Also, in the illustrated embodiment, the surface area A (e.g., the area) of the insulating film 15 (e.g., the third insulating part) facing with the metal sheet 40 (e.g., the metallic component) is larger than the surface area B (e.g., the area) of the insulating film 14 (e.g., the second insulating part) facing with the metal sheet 40 (e.g., the metallic component) as shown in FIG. 3. Also, in the illustrated embodiment, the shield member 12 (e.g., the shield component) is located closer to the metal sheet 40 (e.g., the metallic component) relative to the conductor component 11 (e.g., the wiring component), as shown in FIG. 1C, in the surface area A shown in FIG. 3. Also, in the illustrated embodiment, the first face of the conductor component 11 (or shielded face 16) faces with the metal sheet 40 in the surface area A, while the second face of the conductor component 11 (or unshielded face 17) faces with the metal sheet 40 in the surface area B. Thus, in the illustrated embodiment, the first and second faces of the conductor component 11 face with the metal sheet 40 (e.g., the metallic component), with the surface area A of the first face facing with the metal sheet 40 (e.g., the metallic component) is larger than the surface area B of the second face facing with the metal sheet 40 (e.g., the metallic component).

If the bending angle is 90° as shown in FIG. 3, the orientation of the signal line before and after bending will be perpendicular. Accordingly, there will be almost no cross-talk between return currents, which happens according to the currents of the perpendicular signal lines, and there will also be almost no noise produced by cross-talk.

Meanwhile, if the FFC 10 is bent so that the unshielded face 17 is on the inside, setting the bending angle at 180° should be avoided. A bending angle of 180° means that the angle of crease θ = 90°, and the orientation of the signal lines is changed by 180° by bending. In a case such as this, return current looping will occur at the portion where bending results in parallel overlap of signal lines, and the above-mentioned cross-talk will generate noise. Also, this looping will generate counter-electromotive force, decrease the signal level, and produce fluctuation in characteristic impedance, etc. To avoid such drawbacks, in this embodiment, when the bending is done with the unshielded face 17 to the inside, an upper limit is provided to the angle of crease θ, and the FFC 10 is bent while complying with this upper limit. The upper limit referred to here is a specific angle that is less than 90°. That is, in a state in which the bent part 10a is bent to the second face side (bent so that the unshielded face 17 is on the inside), the angle α formed by a direction towards one end of the conductor component 11 (e.g., the wiring component) from the bent part 10a (one end of the FFC 10) and a direction towards the other end of the conductor component 11 (e.g., the wiring component) from the bent part 10a (the other end of the FFC 10) is a specific angle (0° < α < 180°). Here, the angle α is expressed by 180° minus the bending angle (2θ). Therefore, "the angle α = 0°" refers to a state in which the bending angle is 180°. Conversely, "the angle α = 180°" refers to a state in which the bending angle is 0°, that is, in which the FFC 10 is not bent. The bent part when the unshielded face 17 is on the inside is also called the first bent part. Thus, the illustrated embodiment, the FFC 10 (e.g., the cable) has the bent part 10a that is bent to the second face side. Also, in the illustrated embodiment, the angle α formed by the direction towards the one end of the conductor component 11 (e.g., the wiring component) or FFC 10 from the bent part 10a and the direction towards the other end of the conductor component 11 (e.g., the wiring component) or FFC 10 from the bent part 10a is 0° < α < 180°.

If the FFC 10 is bent with the shielded face 16 on the inside, there is no need for an upper limit to the angle of crease θ, and θ can be 90°. This is because when the FFC 10 is bent with the shielded face 16 on the inside, there are six layers, namely, the insulating film 13, the shield member 12, the insulating film 15, the insulating film 15, the shield member 12, and the insulating film 13, sandwiched between the conductor components 11 before and after bending, at the portion where the signal line (the conductor component 11) overlaps in parallel due to bending. That is, since the signals flowing through the signal line (the conductor component 11) are high-frequency waves, the return current flows only to the surface layer of the shield member 12 due to the so-called skin effect of the shield member 12, and does not go past the insulating film 15. As a result, there is almost none of the above-mentioned cross-talk. The bent part when the shielded face 16 is on the inside is also called the second bent part.

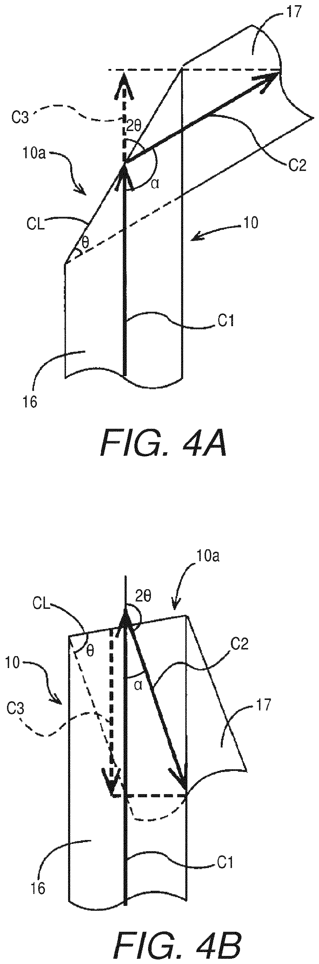

FIGS. 4A and 4B show a portion of the FFC 10 including the bent part 10a. The bent part 10a shown in FIGS. 4A and 4B corresponds to the first bent part, just as with the bent part 10a shown in FIG. 3. The FFC 10 shown in FIGS. 4A and 4B also is the portion of the FFC 10 that extends from a connector connected to the circuit board PB (the connector 20, for example) and is disposed along the metal sheet 40, as well as FIG. 3, but in FIGS. 4A and 4B, the surrounding components, namely, the circuit board PB, the connector 20, and the metal sheet 40, are not shown. FIG. 3 differs from FIGS. 4A and 4B in the angle of crease θ. FIG. 4A is an example of when the angle of crease θ is less than 45° (the bending angle 2θ is less than 90°), and FIG. 4B is an example of when the angle of crease θ is over 45° (the bending angle 2θ is over 90°).

In FIGS. 4A and 4B, the solid-line arrows C1 and C2 are examples of the current before and after bending at the bent part 10a (the current flowing to one of the conductors constituting the conductor component 11). The broken-line arrow C3 is an example of the component parallel to the current whose orientation is indicated by the arrow C2 and the current whose orientation is indicated by the arrow C1. As shown in FIG. 4A, when the angle of crease θ is less than 45°, the components of current with parallel orientation before and after bending (the current components indicated by the arrows C1 and C3) are facing in a direction in which no counter-electromotive force is generated, so there will be no noise produced by cross-talk, etc., and there will be no particular problems. On the other hand, when the angle of crease θ is over 45° as shown in FIG. 4B, the components of current with parallel orientation before and after bending (the current components indicated by the arrows C1 and C3) are facing in a direction in which counter-electromotive force is generated. Therefore, the effect of cross-talk and a fluctuation in characteristic impedance can occur.

Here, let us state as a premise that if the fluctuation in the characteristic impedance of the FFC 10 is within a range of ±10% versus a reference of 100 Ω, this is permissible quality for signal transmission. Actually, the coefficient of variation in the characteristic impedance equals the coefficient of variation from the reference of the inherent characteristic impedance of the FFC 10 plus the coefficient of variation in the characteristic impedance due to bending. Thus, during design, the coefficient of variation from the reference of the inherent characteristic impedance of the FFC 10 must be taken into account in setting the bending angle of the bent part 10a (the first bent part).

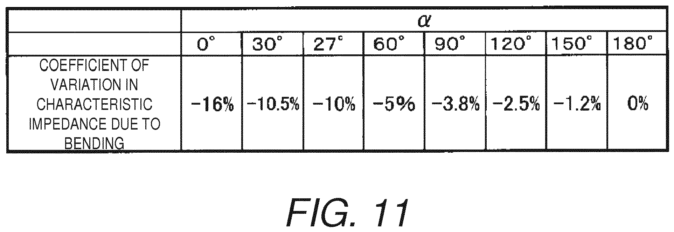

FIG. 11 is a table of the relation between the angle α and the coefficient of variation in the characteristic impedance due to bending at the angle α of the bent part 10a (the first bent part). In FIG. 11, the coefficient of variation at angle α = 180° is a minimum of 0%, and the coefficient of variation at angle α = 0° is a maximum of -16%. If the coefficient of variation from the reference of the inherent characteristic impedance of the FFC 10 is 0%, then as discussed above, under conditions in which the coefficient of variation of characteristic impedance is permitted up to a range of ±10%, a numerical value range of at least 27° and less than 180° can be said to be preferable for the angle α, referring to FIG. 11. Since the angle α is the angle in a state in which the unshielded face 17 has been "bent" so that it faces itself, this is a numerical value range that excludes a state in which the FFC 10 has not been bent (angle α = 180°). Furthermore, if we factor in the fact that there will be a certain amount of coefficient of variation from the reference in the inherent characteristic impedance of the FFC 10, the coefficient of variation of the characteristic impedance due to bending is preferably about ±5%. Therefore, referring to FIG. 11, we can say that a numerical value range of at least 60° and less than 180° is even better. Thus, in the illustrated embodiment, the angle α is preferably 27° ≤ α < 180°. Also, in the illustrated embodiment, the angle α is more preferably 60° ≤ α < 180°. Also, in the illustrated embodiment, the fluctuation in the characteristic impedance of the FFC 10 (e.g., the cable) is less than or equal to 10%.

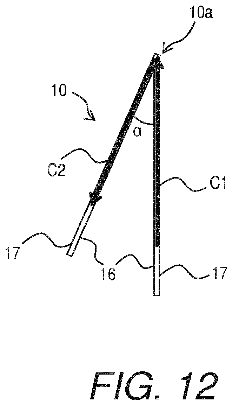

In the illustrated embodiment, the angle $\alpha$ is defined as an angle between the direction towards one end of the conductor component 11 from the bent part 10a and the direction towards the other end of the conductor component 11 from the bent part 10a. Specifically, the angle $\alpha$ is defined as an angle between the direction towards the one end of the conductor component 11 from the bent part 10a along a conductor or a signal wire of the conductor component 11 and the direction towards the other end of the conductor component 11 from the bent part 10a along the conductor or the signal wire of the conductor component 11. Thus, in the illustrated embodiment, the angle $\alpha$ is basically uniquely determined or defined regardless of the viewing direction, and is a specific angle ($0° < \alpha < 180°$, $27° \leq \alpha < 180°$, or $60° \leq \alpha < 180°$, for example). However, the angle $\alpha$ can also be defined as an angle between the direction towards one end of the conductor component 11 from the bent part 10a and the direction towards the other end of the conductor component 11 from the bent part 10a as viewed in a perpendicular direction perpendicular to the shielded surface 16 or the unshielded surface 17 (e.g., main surface) of the FFC 10, as shown in FIGS. 4A and 4B, for example. In this case, the angle $\alpha$ in this plan view can also be a specific angle ($0° < \alpha < 180°$, $27° \leq \alpha < 180°$, or $60° \leq \alpha < 180°$, for example). Also, the angle $\alpha$ can also be defined as an angle between the direction towards one end of the conductor component 11 from the bent part 10a and the direction towards the other end of the conductor component 11 from the bent part 10a as viewed in a parallel direction parallel to the shielded surface 16 or the unshielded surface 17 (e.g., main surface) of the FFC 10, for example. FIG. 12 is a side view of the FFC 10 as shown in FIG. 4B as viewed in the parallel direction to the shielded surface 16. As illustrated in FIG. 12, the angle angle $\alpha$ can be defined as an angle between the arrow C1 and C2 in the side view as viewed in the parallel direction. In this case, the angle $\alpha$ in this side view can also be a specific angle ($0° < \alpha < 180°$, $27° \leq \alpha < 180°$, or $60° \leq \alpha < 180°$, for example).

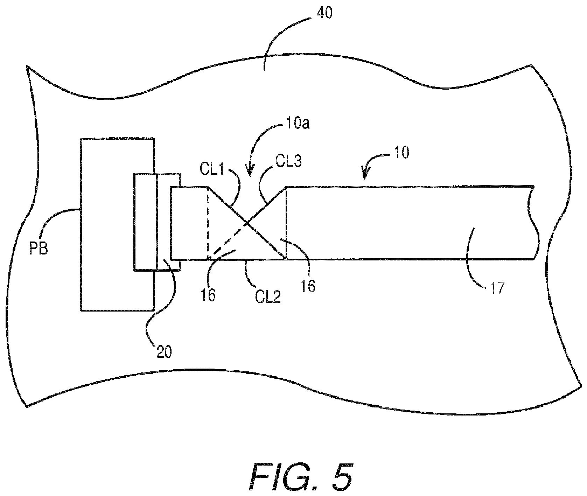

FIGS. 4A and 4B both just show the area near the end of the FFC 10 extending from a connector (not shown in FIGS. 4A and 4B), just as with FIG. 3, and actually the majority of the FFC 10 is in an orientation in which the shielded face 16 faces the metal sheet 40 side due to the bent part 10a. That is, FIGS. 4A and 4B are similar to FIG. 3 in that they show an example of the bent part 10a in which the surface area opposite the shielded face is greater than the surface area opposite the unshielded face. FIGS. 5 to 10 (discussed below) can also be considered examples of the bent part 10a of the FFC 10 configured so that the surface area opposite the shielded face is greater than the surface area opposite the unshielded face. FIGS. 3, 4A and 4B, as well as FIGS. 5 to 10B (discussed below), all show examples of the bent part 10a including at least a first bent part. FIGS. 5, 6A, 6B, 7A, 7B, 8B, 9A and 9 B (discussed below) all show examples of the bent part 10a combining a first bent part and a second bent part.

SECOND EMBODIMENT

FIG. 5 shows an example of part of the FFC 10 disposed on the metal sheet 40 and extending from a connector (such as the connector 20) connected to the circuit board PB, as well as the area around this part. As shown in FIG. 5, the FFC 10 extends from the connector 20 in a state in which the shielded face 16 is facing up (the opposite side from the side where the metal sheet 40 is located). In this state, in the example in FIG. 5, the FFC 10 has at least a bent part 10a that includes one bend at a bending angle of 90° with the unshielded face 17 on the inside (a bend at an angle of crease of 45° to produce the crease line CL1), one bend at a bending angle of 180° with the shielded face 16 on the inside (a bend at an angle of crease of 90° to produce the crease line CL2), and one bend at a bending angle of 90° with the unshielded face 17 on the inside (a bend at an angle of crease of 45° to produce the crease line CL3).

With this configuration including a plurality of bends as shown in FIG. 5, the direction in which the FFC 10 extends from the connector is maintained while the front and rear of the FFC 10 is changed, which allows the proportion of the surface area opposite the shielded face (the ratio of the surface area opposite the shielded face versus the surface area opposite the unshielded face) to be increased as much as possible.

THIRD EMBODIMENT

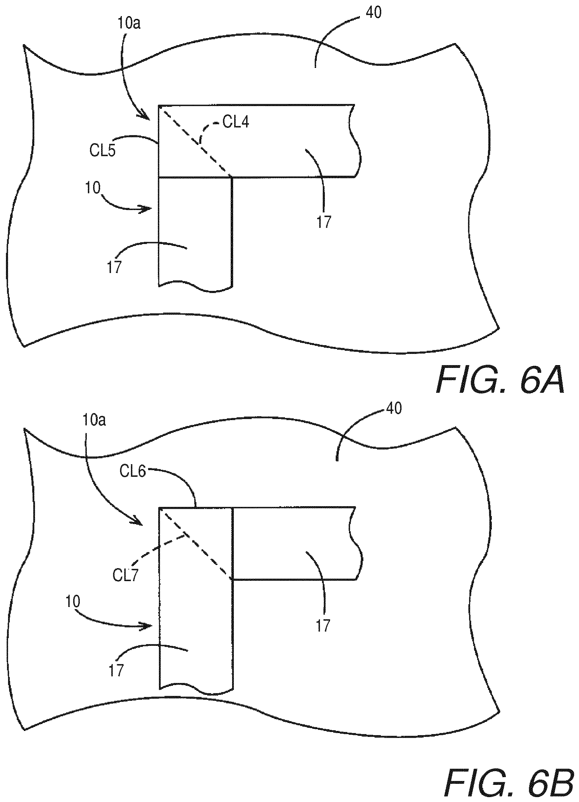

FIGS. 6A and 6B both show an example of part of the FFC 10 disposed on the metal sheet 40, as well as the area around this part. In the example in FIG. 6A, the FFC 10 has at least a bent part 10a that combines one bend at a bending angle of 90° with the unshielded face 17 on the inside in the middle of the extension in a state in which the unshielded face 17 is facing up (the opposite side from the side where the metal sheet 40 is located) (a bend at an angle of crease of 45° to produce the crease line CL4), and one bend at a bending angle of 180° with the shielded face 16 on the inside (a bend at an angle of crease of 90° to produce the crease line CL5).

In the example in FIG. 6B, the FFC 10 has at least a bent part 10a that combines one bend at a bending angle of 180° with the shielded face 16 on the inside in the middle of the extension in a state in which the unshielded face 17 is facing up (the opposite side from the side where the metal sheet 40 is located) (a bend at an angle of crease of 90° to produce the crease line CL6), and one bend at a bending angle of 90° with the unshielded face 17 on the inside (a bend at an angle of crease of 45° to produce the crease line CL7).

With this configuration combining a plurality of bends as shown in FIGS. 6A and 6B, FCC 10 maintains a state in which the shielded face 16 is facing the metal sheet 40 side while the extension direction of the FFC 10 can be changed by 90°. FIGS. 6A and 6B show an example of the bent part 10a in which the number of cable bends is an even number. Thus, in the illustrated embodiment, the number of bends of the FFC 10 is an even number.

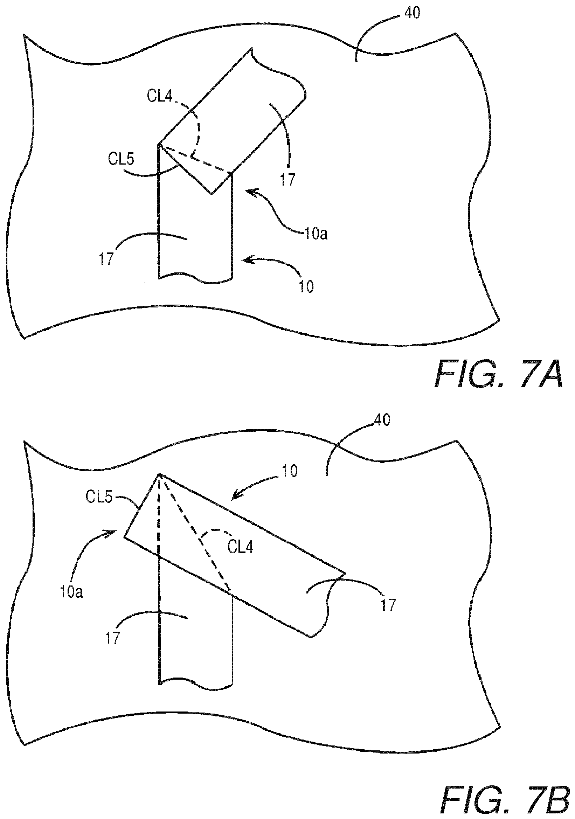

FIGS. 7A and 7B are both a modification example of FIG. 6A. That is, a comparison of FIG. 6A and FIG. 7A reveals that the bend that produces the crease line CL4 with the unshielded face 17 on the inside has an angle of crease of 45° for the former (FIG. 6A), while in the latter (FIG. 7A) the angle of crease is over 45° (although the angle is under the above-mentioned upper limit). Also, a comparison of FIG. 6A and 7B reveals that the bend that produces the crease line CL4 with the unshielded face 17 on the inside has an angle of crease of 45° for the former (FIG. 6A), while in the latter (FIG. 7B) the angle of crease is less than 45°.

With this configuration combining a plurality of bends as shown in FIGS. 7A and 7B, a state in which the shielded face 16 of the FFC 10 is facing the metal sheet 40 side is maintained (although in the example in FIG. 7B, there is a small range over which the unshielded face 17 is facing the metal sheet 40 side), while the extension direction of the FFC 10 can be changed within a range that complies with the above-mentioned upper limit for the angle of crease of a bend with the unshielded face 17 on the inside.

FOURTH EMBODIMENT

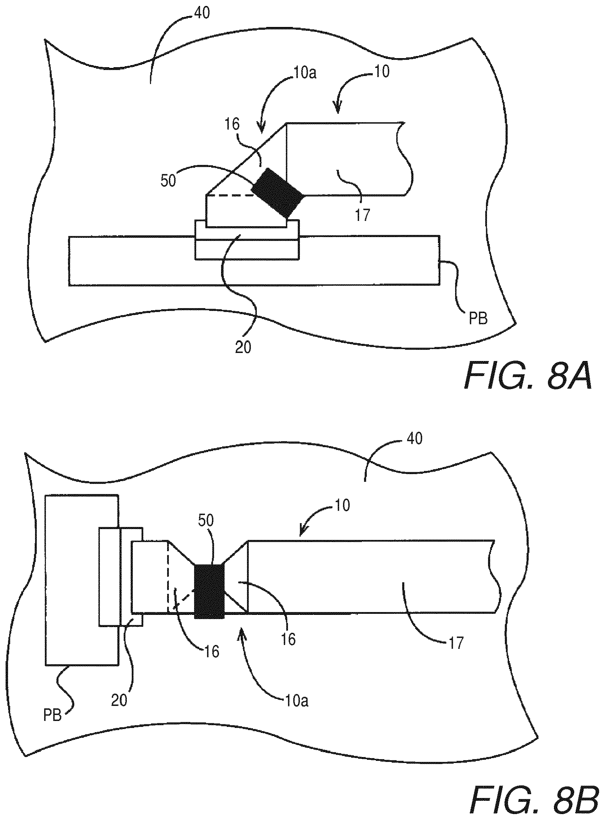

FIG. 8A shows an example of fixing the bent part 10a to the bent part 10a of the FFC 10 shown in FIG. 3 by affixing tape 50. FIG. 8B shows an example of fixing the bent part 10a to the bent part 10a of the FFC 10 shown in FIG. 5 by affixing tape 50. The tape 50 that is used for this fixing can be vinyl electrical tape, polyester film tape, filament tape, an adhesive label, or the like.

When the tape 50 is affixed to the FFC 10, the surface area over which the tape 50 comes into contact with the unshielded face 17 is kept as small as possible. This is because if the tape 50 comes into contact with the unshielded face 17 over a large area, the characteristic impedance of the FFC 10 will tend to fluctuate due to the influence of the dielectric constant of the tape 50 substrate or the adhesive agent or pressure-sensitive adhesive. From this standpoint, in both the examples in FIGS. 8A and 8B, the surface area over which the tape 50 is bonded to the unshielded face 17 is kept as small as possible so that the surface area over which the tape 50 comes into contact with the shielded face 16 can be larger than the surface area over which the tape 50 comes into contact with the unshielded face 17.

It is also possible to affix the tape 50 to the bent part 10a of the FFC 10 shown in FIG. 6A, 6B, 7A or 7B and thereby fixing the bent part 10a. However, if the tape 50 is affixed to the bent part 10a of the FFC 10 shown in FIG. 6A, 6B, 7A or 7B, it will basically be affixed to the unshielded face 17, and this is contrary to the above-mentioned concept of having the surface area over which the tape 50 comes into contact with the shielded face 16 be larger than the surface area over which the tape 50 comes into contact with the unshielded face 17.

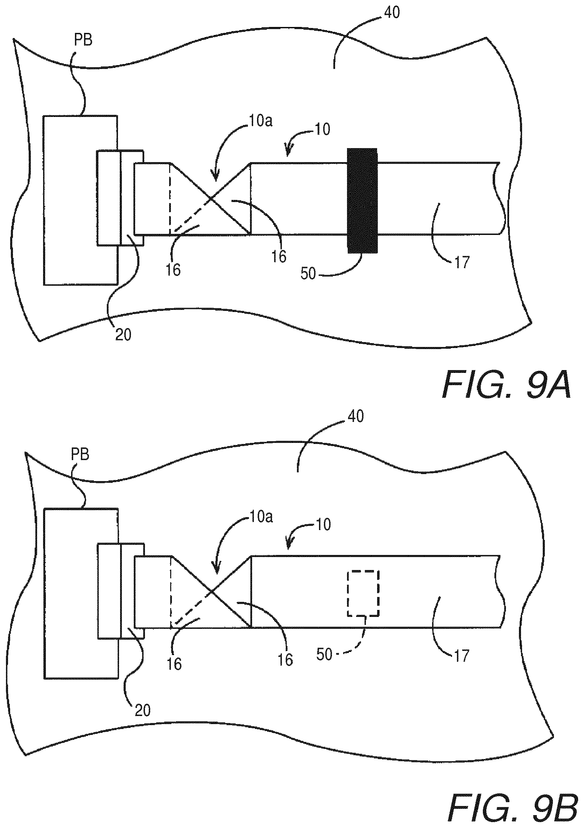

FIGS. 9A and 9B both show an example of fixing the FFC 10 shown in FIG. 5 to the metal sheet 40 with the tape 50. FIG. 9A is an example of fixing the FFC 10 to the metal sheet 40 with the tape 50 that is long enough to span the width of the FFC 10 from above the unshielded face 17 in the range over which the shielded face 16 is touching the metal sheet 40. In this case, since the tape 50 is used in the range over which the shielded face 16 is touching the metal sheet 40, the effect of the tape 50 will not cause any major fluctuation in the characteristic impedance of the FFC 10.

FIG. 9B is an example of fixing the FFC 10 to the metal sheet 40 by inserting the tape 50 between the shielded face 16 and the metal sheet 40 in the range over which the shielded face 16 is touching the metal sheet 40. The tape 50 in FIG. 9B is double-sided tape. In this case, since the tape 50 is touching the shielded face 16, fluctuation of the characteristic impedance of the FFC 10 caused by the effect of the tape 50 is avoided.

FIFTH EMBODIMENT

FIG. 10A is similar to FIG. 3, etc., in that it shows an example of part of the FFC 10 disposed along the metal sheet 40 and extending from a connector (such as the connector 20) connected to the circuit board PB, as well as the area around this part (as seen from the rear face side of the display device 100). Of course, as shown in FIGS. 2A and 2B, the other end of the FFC 10 is connected to another circuit board PB. These circuit boards PB can include the panel drive board 103 (e.g., the drive board) that is configured to transmit the drive signal to the liquid crystal panel 105 (e.g., the display), and the digital board 102 (e.g., the control board) that is configured to control the panel drive board 103. FIG. 10B shows the configuration shown in FIG. 10A, as seen from a side face of the display device 100. FIG. 10B also shows a cross section of part of the rear cabinet 80. In the example in FIGS. 10A and 10B, there are things that serve as obstacles to the routing of the FFC 10, such as a boss 60 and a rib 70, on the rear face side of the metal sheet 40. 41 in FIG. 10B is a protrusion formed by drawing, folding, or otherwise working a part of the metal sheet 40. The protrusion 41 supports the circuit board PB on the rear face side of the metal sheet 40. The metal sheet 40 corresponds to a metal support on which circuit boards are disposed. In this case, in order to route it around an obstacle, the FFC 10 can in some situations have to be longer in the range where the unshielded face 17 faces the metal sheet 40 side (longer than in the example in FIG. 3). In such a situation, the FFC 10 is disposed so that the distance between the FFC 10 and the metal sheet 40 over the range in which the unshielded face 17 is opposite the metal sheet 40 (the distance dx between the unshielded face 17 and the metal sheet 40) is at least a specific distance required for a stable characteristic impedance of the FFC 10. More specifically, the FFC 10 is such that in the range over which the unshielded face 17 is opposite the metal sheet 40, the above-mentioned distance dx is a distance at which the coefficient of variation in the characteristic impedance of the FFC 10 will be 10% or less. Thus, in the illustrated embodiment, the distance dx between the FFC 10 (e.g., the cable) and the metal sheet 40 (e.g., the metallic component) over a range where the second face of the FFC 10 (e.g., the cable) (or the unshielded face 17) faces with the metal sheet 40 (e.g., the metallic component) is more than or equal to the specific distance (e.g., the predetermined distance). In particular, in the illustrated embodiment, the specific distance (e.g., the predetermined distance) is a distance at which the coefficient of variation (or the rate of the fluctuation) in the characteristic impedance of the FFC 10 is less than or equal to 10%. Also, in the illustrated embodiment, the circuit boards PB (e.g., the circuit boards) are disposed on the metal sheet 40 (e.g., the metallic component).

The relation between the distance dx between the unshielded face 17 and the metal sheet 40, and the characteristic impedance Zx of the FFC 10 is expressed by the following Formula 1, for example.
[Formula 1]

$$Zx = \frac{Z_\infty}{\dfrac{\varepsilon_{rx} d_0 (Z_\infty - Z_0)}{Z_0 (\varepsilon_{rx} d_0 + \varepsilon_{r1} dx)} + 1} \quad ...(1)$$

In Formula 1, $Z_0$ is the characteristic impedance when the unshielded face 17 and the metal sheet 40 are in close contact, and $d_0$ is the thickness of the insulating film 14. $\varepsilon_{r1}$ is the dielectric constant of the insulating film. $Z_\infty$ is the characteristic impedance when there is no metal sheet 40 (for example, the characteristic impedance of the FFC 10 serving as a reference (100 $\Omega$)), and $\varepsilon_{rx}$ is the dielectric constant over the range of the distance dx between the unshielded face 17 and the metal sheet 40. Here, if $Z_0 = 86 \Omega$, $d_0 = 60 \mu m$, $\varepsilon_{r1} = 3.5$, and the range over the distance dx between the unshielded face 17 and the metal sheet 40 is air (dielectric constant $\varepsilon_{rx} \approx 1$), then to ensure a Zx of 95 $\Omega$, for example, the distance dx must be approximately 0.375 mm. Zx = 95 $\Omega$ is a coefficient of variation of 5% when the reference for the characteristic impedance of the FFC 10 is 100 $\Omega$, so this corresponds to an example of characteristic impedance that fits within the above-mentioned coefficient of variation of 10% or less. That is, in the example in FIGS. 10A and 10B, the FFC 10 is disposed so as to ensure this distance dx. Furthermore, this distance dx can be ensured by inserting a suitable spacer between the FFC 10 and the metal sheet 40 and maintaining the orientation of the FFC 10 (restricting flexure of the FFC 10). If there is a spacer, the above-mentioned $\varepsilon_{rx}$ will also include the dielectric constant of this spacer. For example, if a spacer and air are present over the range of the distance dx between the unshielded face 17 and the metal sheet 40, the above-mentioned $\varepsilon_{rx}$ will be the dielectric constant of air plus the dielectric constant of the spacer.

While only selected embodiments have been chosen to illustrate the present invention, it will be apparent to those skilled in the art from this disclosure that various changes and modifications can be made herein without departing from the scope of the present invention.

As a result of suitably combining bends as described so far, the FFC 10 is disposed between boards along the path shown in FIG. 2A or 2B. FIGS. 2A and 2B are examples, and the FFC 10 can be disposed along a different path from the one shown in these drawings. In any case, the range over which the FFC 10 is disposed along the metal sheet 40 is routed so that the surface area opposite the shielded face will be greater than the surface area opposite the unshielded face.

FIG. 2B shows an FFC 10 that connects the digital board 102 to the panel drive board 103 on the left side as seen from the rear face side of the display device 100, and an FFC 10 that connects the digital board 102 to the panel drive board 103 on the right side as seen from the rear face side of the display device 100. These two FFCs 10 are in left and right symmetry. Thus connecting the digital board 102 to the panel drive boards 103 with two FFCs 10 in left and right symmetry results in a high-quality video display, without any time lag in the signals transmitted from the digital board 102 to the panel drive boards 103.

Depending on their structure, the connectors 20 and 30 can have the ground terminals on their lower side. The lower side referred to here is the lower side when the side on which the boards are located is called the lower side, in a state in which the connectors 20 and 30 are connected on the boards. When these connectors 20 and 30 are employed, in order to connect the shield member 12 to the ground terminals of the connectors 20 and 30, the FFCs 10 are such that the shielded face 16 is facing down and the unshielded face 17 is facing up. In this case, the FFCs 10 that is disposed along the metal sheet 40 can be oriented such that the shielded face 16 always faces toward the metal sheet 40.

The characteristic feature of this embodiment can be said to increase in importance as the resolution and image quality of the video display rise. For instance, with an LVDS (low voltage differential signaling) standard, which is used for full high definition and other such video display, input to the FFC linking the digital board 102 and the panel drive board 103 is 525 Mbps, and this requires about 1.9 nsec for the transmission of one bit. On the other hand, with a communication standard pertaining to even higher-quality 4K television, input to the FFC linking the digital board 102 and the panel drive board 103 is 3 Gbps, and this requires about 0.33 nsec for the transmission of one bit.

Here, let us assume that we are considering the propagation distance per bit. If we let the dielectric constant $\varepsilon r$ of the insulating film had by the FFC be from 4 to 5, the propagation velocity V needs to be V = $C_0$/sqrt($\varepsilon r$), where V is about 13 cm/nsec. Here, the speed of light $C_0$ = 30 cm/nsec, and sqrt($\varepsilon r$) is the square root of $\varepsilon r$. The above-mentioned LVDS standard requires a propagation distance of 1.9 nsec x 13 cm/nsec = approximately 24.7 cm. On the other hand, with the standard pertaining to the above-mentioned 4K television, a propagation distance of 0.33 nsec x 13 cm/nsec = approximately 4.3 cm is required.

Let us assume that within a 1-cm length midway along the FFC, there is a range in which impedance fluctuates (drops). With the above-mentioned LVDS standard, since the propagation distance per bit is approximately 24.7 cm, the effect on 1 bit of data attributable to this 1-cm range can be said to be 1/24.7, or about 4%. On the other hand, with the above-mentioned standard pertaining to 4K television, since the propagation distance per bit is approximately 4.3 cm, the effect on 1 bit of data attributable to this 1-cm range can be said to be 1/4.3, or about 23%. That is, a consideration such as this leads to the conclusion that as resolution and image quality of the video display rise, the adverse effect on the signals attributable to the range over which FFC impedance fluctuation occurs (such as the range over which the unshielded face 17 is opposite the metal sheet 40, or the range of the unshielded face 17 over which the tape 50 is affixed) becomes more pronounced, so the importance of this embodiment is likely to continue to increase in the future.

The electronic device in which the cable connection structure pertaining to the present invention is installed is not limited to being the display device 100. This electronic device can be any electronic device that has a metal sheet and an FFC that is installed near this metal sheet.

In understanding the scope of the present invention, the term "comprising" and its derivatives, as used herein, are intended to be open ended terms that specify the presence of the stated features, elements, components, groups, integers, and/or steps, but do not exclude the presence of other unstated features, elements, components, groups, integers and/or steps. The foregoing also applies to words having similar meanings such as the terms, "including", "having" and their derivatives. Also, the terms "part," "section," "portion," "member" or "element" when used in the singular can have the dual meaning of a single part or a plurality of parts unless otherwise stated.

As used herein, the following directional terms "forward", "rearward", "front", "rear", "up", "down", "above", "below", "upward", "downward", "top", "bottom", "side", "vertical", "horizontal", "perpendicular" and "transverse" as well as any other similar directional terms refer to those directions of a display device in an upright position. Accordingly, these directional terms, as utilized to describe the display device should be interpreted relative to a display device in an upright position on a horizontal surface. The terms "left" and "right" are used to indicate the "right" when referencing from the right side as viewed from the rear face side of the display device, and the "left" when referencing from the left side as viewed from the rear face side of the display device.

The term "attached" or "attaching", as used herein, encompasses configurations in which an element is directly secured to another element by affixing the element directly to the other element; configurations in which the element is indirectly secured to the other element by affixing the element to the intermediate member(s) which in turn are affixed to the other element; and configurations in which one element is integral with another element, i.e. one element is essentially part of the other element. This definition also applies to words of similar meaning, for example, "joined", "connected", "coupled", "mounted", "bonded", "fixed" and their derivatives. Finally, terms of degree such as "substantially", "about" and "approximately" as used herein mean an amount of deviation of the modified term such that the end result is not significantly changed.

While only selected embodiments have been chosen to illustrate the present invention, it will be apparent to those skilled in the art from this disclosure that various changes and modifications can be made herein without departing from the scope of the invention as defined in the appended claims. For example, unless specifically stated otherwise, the size, shape, location or orientation of the various components can be changed as needed and/or desired so long as the changes do not substantially affect their intended function. Unless specifically stated otherwise, components that are shown directly connected or contacting each other can have intermediate structures disposed between them so long as the changes do not substantially affect their intended function. The functions of one element can be performed by two, and vice versa unless specifically stated otherwise. The structures and functions of one embodiment can be adopted in another embodiment. It is not necessary for all advantages to be present in a particular embodiment at the same time. Every feature which is unique from the prior art, alone or in combination with other features, also should be considered a separate description of further inventions by the applicant, including the structural and/or functional concepts embodied by such feature(s). Thus, the foregoing descriptions of the embodiments according to the present invention are provided for illustration only, and not for the purpose of limiting the invention as defined by the appended claims.

**Claims**

1. A display device comprising:

   a display;
   two circuit boards configured to be electrically connected to the display; and
   a cable electrically connecting the circuit boards and including a sheet-form wiring component having a first face and a second face on the opposite side from the first face, a first insulating part that is disposed on the first face, and a shield component that is disposed on the first insulating part and shields electromagnetic waves; wherein
   the cable has a bent part that is bent to a second face side, and
   the angle $\alpha$ formed by a direction towards one end of the wiring component from the bent part and a direction towards the other end of the wiring component from the bent part is $0° < \alpha < 180°$.

2. The display device according to claim 1, wherein the angle $\alpha$ is $27° \leq \alpha < 180°$.

3. The display device according to claim 1 or 2, wherein the angle $\alpha$ is $60° \leq \alpha < 180°$.

4. The display device according to any one of claims 1 to 3, wherein the number of bends of the cable is an even number.

5. The display device according to any one of claims 1 to 4, wherein the shield component is disposed over an entire surface of the first face.

6. The display device according to any one of claims 1 to 5, wherein the shield component is disposed only on the first face out of the first and second faces.

7. The display device according to any one of claims 1 to 6, wherein
   the circuit boards include a drive board that is configured to transmit drive signal to the display, and a control board that is configured to control the drive board.

8. The display device according to any one of claims 1 to 7, wherein the cable includes a second insulating part that covers at least a part of the second face.

9. The display device according to any one of claims 1 to 8, further comprising
   a metallic component that forms a component of the display device,
   a part of the second insulating part of the cable being located closer to the metallic component relative to the wiring component.

10. The display device according to any one of claims 1 to 9, wherein the cable includes a third insulating part that covers at least a part of the shield component.

11. The display device according to claim 10, further comprising
    a metallic component that forms a component of the display device,
    a part of the third insulating part of the cable being located closer to the metallic component relative to the wiring component.

12. The display device according to claim 11, wherein the area of the third insulating part facing with the metallic component is larger than the area of the second insulating part facing with the metallic component.

13. The display device according to any one of claims 1 to 12, further comprising
    a metallic component that forms a component of the display device,
    the shield component being located closer to the metallic component relative to the wiring component.

14. The display device according to any one of claims 1 to 13, wherein
    the angle $\alpha$ is $0° < \alpha < 180°$ as viewed in a direction perpendicular to a main surface of the cable.

15. The display device according to any one of claims 1 to 13, wherein
    the angle $\alpha$ is $0° < \alpha < 180°$ as viewed in a direction parallel to a main surface of the cable.

FIG. 1A

FIG. 1B

FIG. 1C

FIG. 1D

FIG. 2A

FIG. 2B

# FIG. 3

FIG. 4A

FIG. 4B

FIG. 5

10a

40

CL4

CL5

10

17

17

## FIG. 6A

10a

40

CL6

CL7

10

17

17

## FIG. 6B

FIG. 7A

FIG. 7B

FIG. 8A

FIG. 8B

FIG. 9A

FIG. 9B

FIG. 10A

FIG. 10B

| | $\alpha$ | | | | | | | |
|---|---|---|---|---|---|---|---|---|
| | 0° | 30° | 27° | 60° | 90° | 120° | 150° | 180° |
| COEFFICIENT OF VARIATION IN CHARACTERISTIC IMPEDANCE DUE TO BENDING | −16% | −10.5% | −10% | −5% | −3.8% | −2.5% | −1.2% | 0% |

# FIG. 11

FIG. 12

Europäisches
Patentamt

European
Patent Office

Office européen
des brevets

# EUROPEAN SEARCH REPORT

Application Number

EP 17 15 6061

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 644 092 A (GENTRY WILLIAM G [US]) 17 February 1987 (1987-02-17) * columns 1,2; figures * | 1-3,5,7, 10,14,15 | INV. H05K1/02 |
| Y | | 9,11-13 | ADD. |
| X | US 2002/135993 A1 (UEYAMA TOMOKI [JP] ET AL) 26 September 2002 (2002-09-26) * paragraphs [0018] - [0028]; figures * | 1-3,5-8, 14,15 | H05K1/14 |
| Y | GB 2 034 102 A (XEROX CORP) 29 May 1980 (1980-05-29) * pages 1,2; figures * | 1-8,14, 15 | |
| Y | US 2011/094790 A1 (LIN GWUN-JIN [TW] ET AL) 28 April 2011 (2011-04-28) * paragraphs [0002], [0003], [0010], [0033]; figures * | 1-8,14, 15 | |
| Y | US 2012/230000 A1 (ISHINO YUSUKE [JP] ET AL) 13 September 2012 (2012-09-13) * paragraphs [0024], [0030] - [0033]; figures * | 9,11-13 | |
| A | US 2008/139015 A1 (CHEN SHIH-HSIEN [TW] ET AL) 12 June 2008 (2008-06-12) * paragraphs [0019] - [0024]; figures * | 1-8,14, 15 | TECHNICAL FIELDS SEARCHED (IPC) H05K |

The present search report has been drawn up for all claims

| Place of search | Date of completion of the search | Examiner |
|---|---|---|
| The Hague | 23 June 2017 | Geoghegan, C |

EPO FORM 1503 03.82 (P04C01)

## ANNEX TO THE EUROPEAN SEARCH REPORT
## ON EUROPEAN PATENT APPLICATION NO.

EP 17 15 6061

This annex lists the patent family members relating to the patent documents cited in the above-mentioned European search report.
The members are as contained in the European Patent Office EDP file on
The European Patent Office is in no way liable for these particulars which are merely given for the purpose of information.

23-06-2017

| Patent document cited in search report | | Publication date | Patent family member(s) | | Publication date |
|---|---|---|---|---|---|
| US 4644092 | A | 17-02-1987 | BR | 8606796 A | 13-10-1987 |
| | | | DE | 3669224 D1 | 05-04-1990 |
| | | | EP | 0231256 A1 | 12-08-1987 |
| | | | ES | 297154 U | 16-12-1989 |
| | | | JP | S63500342 A | 04-02-1988 |
| | | | PT | 83005 A | 01-08-1986 |
| | | | US | 4644092 A | 17-02-1987 |
| | | | WO | 8700679 A1 | 29-01-1987 |
| US 2002135993 | A1 | 26-09-2002 | EP | 1296544 A1 | 26-03-2003 |
| | | | US | 2002135993 A1 | 26-09-2002 |
| | | | WO | 0203764 A1 | 10-01-2002 |
| GB 2034102 | A | 29-05-1980 | NONE | | |
| US 2011094790 | A1 | 28-04-2011 | JP | 5404576 B2 | 05-02-2014 |
| | | | JP | 2011096656 A | 12-05-2011 |
| | | | TW | 201116175 A | 01-05-2011 |
| | | | US | 2011094790 A1 | 28-04-2011 |
| US 2012230000 | A1 | 13-09-2012 | EP | 2498586 A2 | 12-09-2012 |
| | | | JP | 2012190722 A | 04-10-2012 |
| | | | US | 2012230000 A1 | 13-09-2012 |
| US 2008139015 | A1 | 12-06-2008 | TW | 200826752 A | 16-06-2008 |
| | | | US | 2008139015 A1 | 12-06-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013191971 A